# EUROPEAN PATENT SPECIFICATION

(11) **EP 3 161 179 B1**
(45) Date of publication and mention of the grant of the patent: **24.04.2019**
(21) Application number: 15732698.4
(22) Date of filing: 30.06.2015
(51) Int. Cl.: C23C 14/12, B05D 1/00

(54) **A PROCESS FOR PREPARATION OF A COMPOSITE LAYER OR A LAMINATE, AND PRODUCT OBTAINED THEREWITH**
VERFAHREN ZUR HERSTELLUNG EINER VERBUNDSCHICHT ODER EINES LAMINATS UND DAMIT HERGESTELLTES PRODUKT
PROCÉDÉ DE PRÉPARATION D'UNE COUCHE COMPOSITE OU D'UN STRATIFIÉ, ET PRODUIT OBTENU À L'AIDE DE CELUI-CI

(30) Priority: 30.06.2014 NL 2013088
(43) Date of publication of application: 03.05.2017
(73) Proprietor: Knowfort Holding B.V., 6167 RD Geleen (NL)
(72) Inventor: JAHROMI, Shahab, NL-6211 PA Maastricht (NL)
(74) Representative: Hoyng Rokh Monegier LLP
(86) International application number: PCT/EP2015/064821
(87) International publication number: WO 2016/001213

(56) References cited:
- JP-A- 2004 076 108
- JP-A- 2010 173 134
- US-B1- 6 218 004

## Description

The invention relates to a process for preparation of a composite layer comprising a substrate, a metal or metal oxide and a coating. The invention further relates to a laminate comprising said composite layer and a further plastic film.

Laminates are used in the packaging, electronic and other industries. Often, the laminates need good barrier properties like low oxygen or water vapor transmission rates. Plastic or paper films need to be coated with one or more layers improving the barrier properties. Substrates, for example polyolefin or polyester films coated with a metal or metal oxide, like e.g. aluminum, aluminum oxide, magnesium oxide or silicium oxide are known. These films are likewise used in the packaging or electronic industry. Such films can have good barrier properties, however the processing of such metal or metal oxide layers that are used to enhance barrier properties may be difficult. For example, alumina coated films are deteriorated for further processing within a few weeks to few months. The situation is worst for aluminum metalized cast polypropylene (CPP) followed by aluminum metalized biaxially oriented polypropylene (BOPP). For metallized CPP for example the surface tension tends to drop from above 40 dyn/cm right after metallization to below 35dyn/cm within 2 weeks. Hence, before a next step, the alumina layer is corona treated. Obviously, this causes a delay in processing, and it is costly. A metal or metal oxide layer may be damaged on micro-level by for example printing or further processing. In particular, aluminum oxide layers and in lesser extent silicon oxide layers which are used for transparent barrier films appear to be very brittle. Often, a coating (lacquer) is applied off line in a separate process step to protect these metal oxide layers.

It would be advantageous if the metal or metal oxide layer could be protected with a coating in a so-called "in-line" process, as no separate off-line coating step would be necessary.

Certain types of barrier coatings are known, such as for example cross linkable acrylate systems. Exemplary disclosures for acrylate systems include US6218004 and JP-A2010/173134. Cross linkable acrylate systems are used, but acrylate monomers are preferably not used in food-contact applications.

It is further described in JP 2004/076108 to use fluorinated vinylidene polymers to coat ferro-electric surfaces. In order to keep the ferro-electric properties, the surface is cooled to -130 °C. As such products are not used in packaging, the adhesive bond between the fluorinated vinylidene polymer and the ferro-electric surface is not demanding.

It is also known to apply melamine as coating and barrier layer in an in-line vapor deposition process; see US6632519. However, such barrier layers based on melamine appear to be deteriorated by moisture.

In WO2010/003958 other crystalline organic compounds are described, as layers to provide barrier and protective properties. It appeared that crystalline compounds may be sensitive for printing and adhesives because of the solvents.

It would be advantageous to provide a process providing a layer that protects the metal or metal oxide layer in an in-line process which is less sensitive for solvents.

Another challenging problem for, in particular transparent, barrier laminates is to withstand retort conditions.

Yet another problem with transparent oxide coated barrier film, in particular aluminum oxide, is that the barrier is deteriorated after an extrusion lamination process.

It would therefore be advantageous to provide a process providing a layer that protects the metal or metal oxide layer in an in-line process such that the metal or metal oxide layer is less sensitive for printing, extrusion lamination and/or retort processes.

It is an object of this invention to provide an alternative barrier film, in which disadvantages of the prior art are at least partly overcome.

It is a further object of the invention is to provide a laminate comprising a substrate, a metal or metal oxide barrier layer with a protective layer having good processing properties and a good lamination strength.

Another object of the invention is to provide a composite layer comprising a substrate, a metal or metal oxide barrier layer with a protective layer that can be applied in line.

Another object of the invention is to provide a composite layer comprising a substrate, a metal or metal oxide barrier layer with a protective layer such that the barrier layer is printable.

Yet another object is to find further compounds that are useful in improving the consistency of surface tension of metal layers after prolonged storage.

One or more of the objects are provided by processes, composite layers and/or laminates according to the teaching provided below.

The invention is defined by the subject-matter of the appended independent claims. Preferred embodiments are defined by the appended dependent claims. The invention relates to a process for preparing a composite layer, by applying an oligomeric organic compound layer on a substrate with a metal or metal oxide layer by vapour deposition, comprising the steps of
a) providing as substrate layer a plastic film,
b) applying a metal or metal oxide layer under reduced pressure on said substrate, and
c) vapour depositing the oligomeric organic compound on the metal or metal oxide layer while the film remains at reduced pressure, wherein the oligomeric compound is evaporated from an oligomeric or polymeric compound comprising a stabiliser.

The process according to the invention is preferably performed in a roll-to-roll process at a speed of at least 1 m/s, preferably at least 6 m/s, and more preferably at least 8 m/s. The speed generally is less than 60 m/sec for practical reasons.

The process according to the invention preferably is performed with rolls of about 1 m wide or more, preferably, about 1.25 m wide, and more preferably between 2 and 5 m wide. The length of the rolls used in the process of the invention are generally about 500 m or more, preferably about 1000 m or more, and more preferably about 2000 m or more. Rolls generally will have a length of 60,000 m (60 km) or less, but this is just for practical purposes.

Such high speed and substantial width are particularly useful in the production of composite layers and laminate films for food packaging.

Vapour-depositing as such is a process known to the skilled person. The vapour-depositing step is carried out at a reduced pressure, i.e. a pressure below atmospheric pressure. In the process according to the invention, the pressure generally is below about 1000 Pa (10 mbar), preferably below about 100 Pa (1 mbar) even more preferably below about 10 Pa (0.1 mbar). In case the oligomeric organic compound deposition takes place in a chamber in which metal or a metal-oxide is deposited, it is more preferable to have a pressure of below about 1 Pa (1x10⁻² mbar) although it is equally possible to reduce the pressure at which the vapour-depositing step is carried out even further. Generally, the vapour-depositing step for metal or metal oxides is carried out at a pressure of about 0.1 Pa (10⁻³ mbar) to 10⁻⁴ Pa (10⁻⁶ mbar). Vapour deposition of organic compound is preferably carried out at a pressure between 10 Pa to 0.1 Pa (1x 10⁻¹ to 1x 10⁻³ mbar).

During the vapour-depositing step, the temperature of the substrate is about -60°C or higher, preferably about -30°C or higher, and even more preferable about -20°C or higher, and most preferable about -15°C or higher. The temperature of the substrate generally will be about +125°C or lower, preferably about +100°C or lower, even more preferably about +80°C or lower, and most preferably about 30 °C or lower. The temperature of the substrate is defined herein as the temperature of the part of the substrate that is not being vapour-deposited. For example, if the vapour-depositing step is done on a film which is guided over a temperature-controlled coating drum, the temperature of the substrate is the temperature at which the coating drum is controlled, thus the temperature of the surface section of the film that is in immediate contact with the coating drum. In such a case, and in view of the fact that the to be deposited compounds often have a much higher temperature than 125°C, it will typically occur - as is known - that the temperature of the side of the substrate that is being deposited is higher than the temperature of the side that is not being deposited. Preferably, the substrate is kept at a temperature of about 50 °C or lower.

One method of ensuring that the substrate has a defined temperature is applicable in case there is at least one section, plane or side of the substrate where no layer is to be vapour-deposited; the said section, plane or side can then be brought into contact with a cooled or heated surface to bring the temperature to a desired level and keep it there. As an example, in case the substrate is a film and the vapour-depositing step is executed as a semi-continuous or continuous process whereby the layer will be deposited on one side of the film, the said film preferably is guided over a temperature-controlled roll, also known as coating drum, in such a fashion that the other side of the film - where no layer will be deposited - is in contact with the temperature-controlled roll before and/or during and/or following the vapour-depositing step.

An apparatus suitable to implement the present invention is an apparatus for depositing a metal or metal-oxide and an oligomeric organic compound under vacuum on a substrate, comprising winding rolls and at least one vacuum chamber with a metal or metal-oxide deposition part and an oligomeric organic compound deposition part, the oligomeric organic compound deposition part comprising an oligomeric organic compound evaporator.

In one embodiment, the evaporator is preferably placed outside the vacuum chamber, but it is linked by a heated gas into the vacuum chamber. This has the advantage that the evaporator can stay at the operating temperature when the vacuum chamber is opened to place the next roll which is to be coated. In this way the effective cycle times can be increased.

Preferably, the organic compound deposition part comprises a cooling drum. It is furthermore beneficial to separate by a partition wall the evaporation zone for metal (oxide) from evaporation zone for organic material. This would prevent mixing of two vapours which will results in better performance.

The substrate layer is a plastic film.

As will be explained further in detail below, the composite layer so obtained can be laminated with a further plastic film. The composite layer may first be printed, and thereafter laminated, either while using an adhesive, or by direct lamination (extrusion lamination and coating).

The film for either the substrate, or the sealing film in a laminate may consist of a homogeneous material, or it may itself be non-homogeneous or a composite material. The film may comprise various layers. Preferably, the film comprises a polymeric material. Examples of polymeric compounds are thermoplastic compounds and thermosetting compounds. Suitable examples of thermoplastic compounds include polyolefins, polyolefin-copolymers, polyvinylalcohol, polystyrenes, polyesters and polyamides. Further preferred thermoplastic compounds are biodegradable polymers like poly-lactic acid (PLA), polyglycolideacid (PGA), co-poly lactic acid/glycolic acid (PLGA) and the like.

Suitable examples of non-degradable polymers include HD or LD polyethlylene (PE), LLD polyethylene, ethylene-propylene copolymers, ethylene-vinylacetate copolymer, polyproplylene (PP) and polyethylene terephtalate (PET). These thermoplastic compounds are often used in the form of a film, either as such or oriented; such orientation may be biaxial. Suitable examples include cast polypropylene (CPP), biaxially oriented polypropylene film (BOPP), biaxially stretched polyamide (BOPA) and biaxially oriented polyethylene terephthalate (BOPET). For deposition of metal or metal oxide special grade of BOPP films may be used where a thin layer of high surface tension polymer may be co-extruded or coated as a top skin layer. Suitable special type of BOPP are described for example in WO2013/141918 A1. The film may also comprise a layer of paper.

The laminate preferably has a plastic film as substrate, and one laminating film. These plastic films may be the same or different, and preferably are both chosen from the list above.

The substrate may be pretreated with plasma treatment, and/or may comprise a primer (so-called chemically coated films). Suitable primers include crosslinkable coatings like polyacrylate based coatings, epoxy based coatings and the like. These coatings preferably comprise nano-particle like for example silica, titaniumdioxide, ceriumoxide and the like. In a preferred embodiment, curable silica-based coatings appear to be very suitable, allowing barrier layers that are stable under high humidity.

In one embodiment of the invention, a pre-coat is applied to the substrate before applying the metal or metal oxide, preferably a vapor deposited oligomeric organic compound. This has the advantage that the substrate has a more even surface, and/or the adhesion can be improved. The process of vacuum coating an organic material followed by metal oxide can be repeated in one pumping and in the same chamber and thus producing a composite layer of interchanging organic and metal oxide layers with superior barrier properties suitable for production of flexible electronics such as devices based on organic light emitting diodes and photovoltaics.

The substrate has a vapour-deposited layer of a metal or metal oxide. Suitable metals and oxides include but are not limited to aluminium, copper, gold, silver, iron, magnesium, silicium or titanium. Preferred examples include aluminium, aluminium oxide, magnesium oxide, silicon oxide and silicon nitride.

The metal or metal oxide generally is applied on the substrate by physical vapour deposition (PVD), plasma assisted PVD, plasma enhanced chemical vapour deposition (PECVD), sputtering or atomic layer deposition (ALD). "Atomic Layer Deposition"' (ALD) is the thin film deposition process which applies self-limiting or sequentially self-terminating films via chemical vapour deposition. ALD uses chemicals called precursors and alternating surface reactions to grow self-limiting layers of film. By repeating the process of growing individual layers, thin films can be applied to surfaces. The deposition of metal or metal oxide layers are generally performed under vacuum.

The metal or metal oxide layer generally has a thickness of about 4 nm or more, preferably about 8 nm or more. Generally, the thickness will be about 100 µm or less, preferably about 40 µm or less.

Adhesion of the metal or metal layer to the substrate preferably is sufficiently strong to withstand tearing apart at 0.79 or 1.18 N/cm (2 or 3 N/inch) force. Adhesion may be dependent on the substrate, and for example for polyolefin films adhesion can be improved, in comparison with untreated substrates. Preferred methods to improve adhesion strength of the metal or metal oxide layer to a plastic layer include plasma, corona, UV radiation or electron beam treatment of the substrate. Plasma treatment is preferably carried out inline in the vacuum chamber.

In yet another embodiment, the metal or metal-oxide layer is treated with a silane coupling agent to increase the adhesion.

The oligomeric organic compound as present on the metal or metal-oxide layer is non-aliphatic (thus, it has polar groups) such that the compound is sufficient polar to adhere well to the substrate.

The molecular weights of the oligomeric organic compound as present on the metal or metal-oxide layer in general will be higher than 500, preferably higher than 1000. The oligomeric organic compound is not polymerized on the surface, as that causes substantial processing problems. Generally, the molecular weight will be about 100,000 or lower, preferably about 50,000 or lower, and most preferably about 20,000 or lower..

Generally, about 50 wt% of the oligomeric organic compound layer will have a molecular weight lower than about 30,000; preferably about 50 wt% of the organic oligomer will have a molecular weight of about 20,000 or lower.

The molecular weight can be measured by gel permeation chromatography (GPC) using polystyrene as standard.

The organic compound as evaporated preferably has a vapour pressure of about 0.1 Pa (0.001 mBar) or higher at 280 °C. Preferably, the vapour pressure is about 1 Pa or higher. Generally, the vapour pressure will be about 1000 Pa (100 mBar) or lower.

The oligomeric organic compound is largely amorphous, although the polymeric or oligomeric compounds may exhibit (micro)crystalline behavior, as long as the overall behavior is amorphous. Amorphous is defined by the fact that when analyzing the vapour deposited organic layer by X-ray diffraction (XRD), it should not show any diffraction patterns representing ordening of molecules or polymer chains below 5nm.

For protecting the activity of alumina, it is preferred that the oligomeric organic compound has a Tg or rubbery-to-plastic phase-transition, of 20 °C or more, preferably 50 °C or more. Preferably the vapour deposited organic compound should maintain the surface tension of aluminum metallized layer above 40 dyn/cm for a prolonged period of time (> 3-6 months).

The oligomeric organic compound layer can be made from a variety of oligomer or polymers.

In this application, oligomers are considered to have a molecular weight of about 30,000 Da or lower. Polymers are compounds having a higher molecular weight than 30,000 Da.

Oligomers and polymers can be heated in an evaporator. Polymers will have a low vapour pressure, but will be cleaved when heated at sufficiently high temperature. In this way, sufficient vapour pressure can be obtained for deposition on the metal or metal-oxide layer.

The specific heat for polymeric compounds (Cp) are preferably between 0. 01 and 50 Jg⁻¹K⁻¹ and more preferably between 0. 1 and 5 Jg⁻¹K⁻¹. These values are given under the assumption that there is no thermal degradation when Cp is measured by differential scanning calorimetry (DSC) under an inert atmosphere at rate of 20K/min.

The specific heat of sublimation for organic materials should be preferably between -2000 to 2000 kJ·mol⁻¹, and more preferably between -1000 to 1000 kJ·mol⁻¹ and even more preferably between -100 and 100 kJ·mol⁻¹.

In one embodiment, surprisingly, organic compounds perform very good as a top coat on metal or metal oxide provided that they have a high solubility in alcohols, such as ethanol, ethoxypropanol, methoxypropanol and n-propanol, and/or esters, such as ethyl acetate and n-propyl acetate, and/or ketones such as methyl ethyl ketone, and/or toluene and/or water. The solubility of organic compounds in these solvents is 0,01 gram/100 gram of solvent or higher, preferably 0,1 gram/100 gram of solvent or higher, and even more preferable about 1 gram/100 gram of solvent or higher, and most preferable about 2 gram/100 gram of solvent or higher. The solubility of organic compound in the solvents generally will be about 50 gram/100 gram of solvent or lower, preferably about 20 gram/100gram of solvent or lower, even more preferably about 10 gram/100 gram of solvent or lower, and most preferably about 5 gram/100 gram of solvent or lower.

The thickness of the oligomeric organic compound layer as formed on the substrate in the vapour-depositing step depends on its intended purpose, and can thus vary within wide limits. Preferably, the thickness of the layer is about 5 µm or less, and even more preferably about 1 µm or less as with such lower thickness the transparency is improved. The thickness may be for example about 500 nm or less for cost reasons. The minimum thickness is preferably about 2 nm or more, more preferably about 10 nm or more, and even more preferred about 100 nm or more as such thickness improves the protective properties. For example, the thickness can be about 200 or 300 nm or more. On aluminium metallized layers, the thickness of vapour deposited organic layer is preferably between 5-60nm and on metal oxide layer preferably between 5-500nm. The thickness of oligomeric organic compound is measured, preferably inline, by various (optical) techniques such as UV-spectroscopy, FTIR, refractive index sensors and elipsometry.

In one embodiment, the thickness of the layer is between 2 and 20 nm, even more preferably 5-15 nm. This embodiment is particularly preferred, in case the oligomeric organic compound layer has a high solubility in one or more of the solvents described above.

Suitable polymers include polyolefins, polyethers, polyesters, polyamides and the like.

In one embodiment of the invention, the polymer or oligomer comprises polar groups.

Suitable polymers with polar groups include polyvinylacetate, polyvinylalcohol (PVOH), thermoplastic polyester (like PET or PBT), polylactides, polyglycolides, polylactones, polyhydroxybutyrate-valerate polymers, polyamides (nylons), polycarbonates, ethylene-acrylic polymers, chlorinated polyethylenes, polyurethanes, styrene-maleic acid anhydride copolymers, vinylidene chloride polymers, copolymers of ethylene and vinyl alcohol, poly(ethylene glycol), polyvinyl pyrrolidone, polyvinyl alcohol, polyacrylic acid, polyacrylamides, N-(2-Hydroxypropyl) methacrylamide, Divinyl Ether-Maleic Anhydride, Polyoxazoline, Polyphosphates, Polyphosphazenes, and the like. Other polymers include natural water soluble polymers like Xanthan Gum, Pectins, Chitosan derivatives, Dextran, Carrageenan, Guar Gum, Hydroxypropylmethyl cellulose, Hydroxypropyl cellulose, Hydroxyethyl cellulose, Sodium carboxy methyl cellulose, Albumin, and Starch or Starch based derivatives.

Preferably, non-chlorinated polymers are used, as that increases the possibility of recycling. More generally, preferably, non-halogenated polymers or oligomers are used in the methods and products of the inventions.

Preferably, PVOH, PET or polyamides are used.

In another embodiment, the polymer or oligomer is an a-polar polymer. Suitable a-polar polymers include polyolefins like polyethylene or polypropylene, and polystyrene. With these polymers, it is possible to introduce polar groups during the evaporation step with a plasma treatment using oxygen as plasma gas, in the space between the evaporator and the deposition surface.

The oligomer or polymers used as material in the evaporator comprises a stabilizer. Suitable stabilizers include antioxidants and/or heat stabilizers.

Suitable antioxidants include phenolic anti-oxidants, organic phosphorus compounds and lactone (benzofuranone) stabilizers.

The amount of stabilizer preferably will be in the range of 0.01 to about 1 wt%, preferably about 0.1 to about 0.5 wt%.

Phenolic antioxidants are known and are for instance:
Alkylated monophenols, for example 2,6-di-tert-butyl-4-methylphenol, 2-tert-butyl-4,6-di-methylphenol, 2,6-di-tert-butyl-4-ethylphenol, 2,6-di-tert-butyl-4-n-butylphenol, 2,6-di-tert-butyl-4-isobutylphenol, 2,6-dicyclopentyl-4-methylphenol, 2-(a-methylcyclohexyl)-4,6-dimethyl- phenol, 2,6-dioctadecyl-4-methylphenol, 2,4,6-tricyclohexylphenol, 2,6-di-tert-butyl-4-meth-oxymethylphenol, nonylphenols which are linear or branched in the side chains, for example, 2,6-di-nonyl-4-methylphenol, 2,4-dimethyl-6-(1'-methylundec-1'-yl)phenol, 2,4-dimethyl-6-(1'-methylheptadec-1'-yl)phenol, 2,4-dimethyl-6-(1'-methyltridec-1'-yl)phenol Pentaerythritol tetrakis(3-(3,5-di-tert-butyl-4-hydroxyphenyl)propionate), Octadecyl-3-(3,5-di-tert.butyl-4-hydroxyphenyl)-propionate, Thiodiethylene bis[3-(3,5-di-tert.-butyl-4-hydroxy-phenyl)propionate], Ethylenebis(oxyethylene)bis-(3-(5-tert-butyl-4-hydroxy-m-tolyl)-propionate) and mixtures thereof.

Alkylthiomethylphenols, for example 2,4-dioctylthiomethyl-6-tert-butylphenol, 2,4-dioctyl-thiomethyl-6-methylphenol, 2,4-dioctylthiomethyl-6-ethylphenol, 2,6-di-dodecylthiomethyl-4- nonylphenol.

Hydroquinones and alkylated hydroquinones, for example 2,6-di-tert-butyl-4-methoxyphenol, 2,5-di-tert-butylhydroquinone, 2,5-di-tert-amylhydroquinone, 2,6-diphenyl-4-octadecyloxy-phenol, 2,6-di-tert-butylhydroquinone, 2,5-di-tert-butyl-4-hydroxyanisole, 3,5-di-tert-butyl-4- hydroxyanisole, 3,5-di-tert-butyl-4-hydroxyphenyl stearate, bis-(3,5-di-tert-butyl-4-hydroxy-phenyl) adipate.

Tocopherols, for example α-tocopherol, β-tocopherol, γ-tocopherol, δ-tocopherol and mixtures thereof (Vitamin E).

Hydroxylated thiodiphenyl ethers, for example 2,2'-thiobis(6-tert-butyl-4-methylphenol), 2,2'-thiobis(4-octylphenol), 4,4'-thiobis(6-tert-butyl-3-methylphenol), 4,4'-thiobis(6-tert-butyl-2-methylphenol), 4,4'-thiobis-(3,6-di-sec-amylphenol), 4,4'-bis(2,6-dimethyl-4-hydroxyphenyl)disulfide.

Alkylidenebisphenols, for example 2,2'-methylenebis(6-tert-butyl-4-methylphenol), 2,2'-methylenebis(6-tert-butyl-4-ethylphenol), 2,2'-methylenebis[4-methyl-6-(α-methylcyclohexyl)- phenol], 2,2'-methylenebis(4-methyl-6-cyclohexylphenol), 2,2'-methylenebis(6-nonyl-4-methyl phenol), 2,2'-methylenebis(4,6-di-tert-butylphenol), 2,2'-ethylidenebis(4,6-di-tert-butylphenol), 2,2'-ethylidenebis(6-tert-butyl-4-isobutylphenol), 2,2'-methylenebis[6-(α-methylbenzyl)-4-nonylphenol], 2,2'-methylenebis[6-(α,α-dimethylbenzyl)-4-nonyl phenol], 4,4'-methylenebis-(2,6-di-tert-butylphenol), 4,4'-methylenebis(6-tert-butyl-2-methylphenol), 1,1-bis(5-tert-butyl-4-hydroxy-2-methylphenyl)butane, 2,6-bis(3-tert-butyl-5-methyl-2-hydroxybenzyl)-4-methyl-phenol, 1,1,3-tris(5-tert-butyl-4-hydroxy-2-methylphenyl)butane, 1,1-bis(5-tert-butyl-4-hydroxy-2-methyl-phenyl)-3-n-dodecylmercaptobutane, ethylene glycol bis[3,3-bis(3'-tert-butyl-4'-hydroxyphenyl)butyrate], bis(3-tert-butyl-4-hydroxy-5-methyl-phenyl)dicyclopentadiene, bis[2-(3'-tert-butyl-2'-hydroxy-5'-methylbenzyl)-6-tert-butyl-4-methylphenyl]terephthalate, 1,1-bis-(3,5-dimethyl-2-hydroxyphenyl)butane, 2,2-bis-(3,5-di-tert-butyl-4-hydroxyphenyl)propane, 2,2-bis-(5-tert-butyl-4-hydroxy2-methylphenyl)-4-n-dodecylmercaptobutane, 1,1,5,5-tetra-(5- tert-butyl-4-hydroxy-2-methylphenyl)pentane.

O-, N-and S-benzyl compounds, for example 3,5,3',5'-tetra-tert-butyl-4,4'-dihydroxydibenzyl ether, octadecyl-4-hydroxy-3,5-dimethylbenzylmercaptoacetate, tridecyl-4-hydroxy-3,5-di-tert-butylbenzylmercaptoacetate, tris(3,5-di-tert-butyl-4-hydroxybenzyl)amine, bis(4-tert-butyl-3-hydroxy-2,6-dimethylbenzyl)dithioterephthalate, bis(3,5-di-tert-butyl-4-hydroxy-benzyl)sulfide, isooctyl-3,5-di-tert-butyl-4-hydroxybenzylmercaptoacetate.

Hydroxybenzylated malonates, for example dioctadecyl-2,2-bis-(3,5-di-tert-butyl-2-hydroxy-benzyl)-malonate, di-octadecyl-2-(3-tert-butyl-4-hydroxy-5-methylbenzyl)-malonate, di-dodecylmercaptoethyl-2,2-bis-(3,5-di-tert-butyl-4-hydroxybenzyl)malonate, bis[4-(1,1,3,3-tetra-methylbutyl)phenyl]-2,2-bis(3,5-di-tert-butyl-4-hydroxybenzyl)malonate.

Aromatic hydroxybenzyl compounds, for example 1,3,5-tris-(3,5-di-tert-butyl-4-hydroxy- benzyl)-2,4,6-trimethylbenzene, 1,4-bis(3,5-di-tert-butyl-4-hydroxybenzyl)-2,3,5,6-tetramethylbenzene, 2,4,6-tris(3,5-di-tert-butyl-4-hydroxybenzyl)phenol.

Triazine Compounds, for example 2,4-bis(octylmercapto)-6-(3,5-di-tert-butyl-4-hydroxy-anilino)-1,3,5-triazine, 2-octylmercapto-4,6-bis(3,5-di-tert-butyl-4-hydroxyanilino)-1,3,5-triazine, 2-octylmercapto-4,6-bis(3,5-di-tert-butyl-4-hydroxyphenoxy)-1,3,5-triazine, 2,4,6-tris-(3,5-di-tert-butyl-4-hydroxyphenoxy)-1,2,3-triazine, 1,3,5-tris-(3,5-di-tert-butyl-4-hydroxybenzyl)isocyanurate, 1,3,5-tris(4-tert-butyl-3-hydroxy-2,6-dimethylbenzyl)isocyanurate, 2,4,6-tris-(3,5-di-tert-butyl-4-hydroxyphenylethyl)-1,3,5-triazine, 1,3,5-tris(3,5-di-tert-butyl-4-hydroxy-phenylpropionyl)-hexahydro-1,3,5-triazine, 1,3,5-tris(3,5-dicyclohexyl-4-hydroxybenzyl)isocyanurate. Other suitable triazine compounds include melamine, melem, melam and the like.

Benzylphosphonates, for example dimethyl-2,5-di-tert-butyl-4-hydroxybenzylphosphonate, diethyl-3,5-di-tert-butyl-4-hydroxybenzylphosphonate, dioctadecyl3,5-di-tert-butyl-4-hydroxy- benzylphosphonate, dioctadecyl-5-tert-butyl-4-hydroxy-3-methylbenzylphosphonate, the calcium salt of the monoethyl ester of 3,5-di-tert-butyl-4-hydroxybenzylphosphonic acid.

Acylaminophenols, for example 4-hydroxylauranilide, 4-hydroxystearanilide, octyl N-(3,5-di-tert-butyl-4-hydroxyphenyl)carbamate.

Esters of β-(3,5-di-tert-butyl-4-hydroxyphenyl)propionic acid with mono- or polyhydric alcohols, e.g. with methanol, ethanol, n-octanol, i-octanol, octadecanol, 1,6-hexanediol, 1,9- nonanediol, ethylene glycol, 1,2-propanediol, neopentyl glycol, thiodiethylene glycol, diethylene glycol, triethylene glycol, pentaerythritol, tris(hydroxyethyl) isocyanurate, N,N'-bis(hydroxyethyl)oxamide, 3-thiaundecanol, 3-thiapentadecanol, trimethylhexanediol, trimethylol-propane, 4-hydroxymethyl-1-phospha-2,6,7-trioxabicyclo[2.2.2]octane.

Esters of β-(5-tert-butyl-4-hydroxy-3-methylphenyl)propionic acid with mono- or polyhydric alcohols, e.g. with methanol, ethanol, n-octanol, i-octanol, octadecanol, 1,6-hexanediol, 1,9- nonanediol, ethylene glycol, 1,2-propanediol, neopentyl glycol, thiodiethylene glycol, di-ethylene glycol, triethylene glycol, pentaerythritol, tris(hydroxyethyl) isocyanurate, N,N'-bis-(hydroxyethyl)oxamide, 3-thiaundecanol, 3-thiapentadecanol, trimethylhexanediol, trimethylolpropane, 4-hydroxymethyl-1-phospha-2,6,7-trioxabicyclo[2.2.2]octane.

Esters of β-(3,5-dicyclohexyl-4-hydroxyphenyl)propionic acid with mono- or polyhydric alcohols, e.g. with methanol, ethanol, octanol, octadecanol, 1,6-hexanediol, 1,9-nonanediol, ethylene glycol, 1,2-propanediol, neopentyl glycol, thiodiethylene glycol, diethylene glycol, tri-ethylene glycol, pentaerythritol, tris(hydroxyethyl)isocyanurate, N,N'-bis(hydroxyethyl)oxamide, 3-thiaundecanol, 3-thiapentadecanol, trimethylhexanediol, trimethylolpropane, 4-hydroxymethyl-1-phospha-2,6,7-trioxabicyclo[2.2.2]octane.

Esters of 3,5-di-tert-butyl-4-hydroxyphenyl acetic acid with mono- or polyhydric alcohols, e.g. with methanol, ethanol, octanol, octadecanol, 1,6-hexanediol, 1,9-nonanediol, ethylene glycol, 1,2-propanediol, neopentyl glycol, thiodiethylene glycol, diethylene glycol, triethylene glycol, pentaerythritol, tris(hydroxyethyl)isocyanurate, N,N'-bis(hydroxyethyl)oxamide, 3- thiaundecanol, 3-thiapentadecanol, trimethylhexanediol, trimethylolpropane, 4-hydroxy-methyl-1-phospha-2,6,7-trioxabicyclo[2.2.2]octane.

Amides of β-(3,5-di-tert-butyl-4-hydroxyphenyl)propionic acid e.g. N,N'-bis(3,5-di-tert-butyl-4-hydroxyphenylpropionyl)hexamethylenediamide, N,N'-bis(3,5-di-tert-butyl-4-hydroxyphenyl-propionyl)trimethylenediamide, N,N'-bis(3,5-di-tert-butyl-4-hydroxyphenylpropionyl)hydrazide, N,N'-bis[2-(3-[3,5-di-tert-butyl-4-hydroxyphenyl]propionyloxy)ethyl]oxamide (Naugard (RTM) XL-1 supplied by Uniroyal).

Organic phosphorus compounds are known polymer stabilizers.

Known phosphite and phosphonite stabilizers include for example triphenyl phosphite, di-phenyl alkyl phosphites, phenyl dialkyl phosphites, tris(nonylphenyl) phosphite, trilauryl phos- phite, trioctadecyl phosphite, distearyl pentaerythritol diphosphite, tris(2,4-di-tert-butylphenyl) phosphite, bis(2,4-di-α-cumylphenyl) pentaerythrtitol diphosphite, diisodecyl pentaerythritol diphosphite, bis(2,4-di-tert-butylphenyl) pentaerythritol diphosphite, bis(2,6-di-tert-butyl-4- methylphenyl) pentaerythritol diphosphite, bisisodecyloxy-pentaerythritol diphosphite, bis-(2,4-di-tert-butyl-6-methylphenyl) pentaerythritol diphosphite, bis(2,4,6-tri-tert-butylphenyl) pentaerythritol diphosphite, tristearyl sorbitol triphosphite, tetrakis (2,4-di-tert-butylphenyl) 4,4'-biphenylene-diphosphonite, 6-isooctyloxy-2,4,8,1O-tetra-tert-butyl-dibenzo[d,f][1,3,2]-dioxaphosphepin, 6-fluoro-2,4,8,1O-tetra-tert-butyl-12-methyl-dibenzo[d,g][1,3,2]dioxa-phosphocin bis(2,4-di-tert-butyl-6-methylphenyl) methyl phosphite, bis(2,4-di-tert-butyl-6-methylphenyl) ethyl phosphite, 2,2',2"-nitrilo[triethyltris(3,3'5,5'-tetra-tert-butyl-1,1'-biphenyl-2,2'-diyl)phosphite], bis(2,4-di-t-butylphenyl) octylphosphite, poly(4,4'-{2,2'-dimethyl-5,5'-di-t-butylphenylsulfide}-octylphosphite), poly(4,4'{-isopropylidenediphenol}-octylphosphite), poly(4,4'-{isopropylidenebis[2,6-dibromophenol]}-octylphosphite), or poly(4,4'-{2,2'-dimethyl-5,5'-di-t-butylphenylsulfide}-pentaerythrityl diphosphite).

The organic phosphorus compounds are for instance di-hydrocarbyl hydrogen phosphonates of the general formula (RO)₂P(=O)H. Each R independently is defined as hydrocarbyl. For instance, the di-hydrocarbyl hydrogen phosphonates are diethyl phosphonate, distearyl phosphonate, dibenzyl phosphonate, di(2-ethylhexyl)phosphonate, or di-n-octylphosphonate.

Di-hydrocarbyl hydrogen phosphonates are disclosed for instance in U.S. Pat. No. 4,433,087, incorporated herein by reference.

Di-hydrocarbyl means substituted with two hydrocarbyl (R) groups. The hydrocarbyl groups are for instance phenyl or alkyl or phenylalkyl groups. Phenyl groups are unsubstituted or substituted one to three times with C₁-C₈ alkyl groups or with alkyl groups interrupted with a COO or a OPOO group as set forth in the structures above. Alkyl is for example straight or branched C₁-C₂₄ alkyl. Phenylalkyl is for example benzyl.

Di-hydrocarbyl hydrogen phosphonites are compounds of general formula RO-(R)-P(=O)H. Each R is independently defined as hydrocarbyl. The phosphonite compounds are for instance analogues of the above phosphonates. Such phosphonites are disclosed for example in U.S. Pat. Nos. 4,940,772, 5,717,127 and 5,734,072, each incorporated herein by reference. The compound 9,10-dihydro-9-oxa-10-phosphaphenanthrene 10-oxide is an example

Lactone (benzofuranone) stabilizers are known and are described for example in U.S. Patent No. 6,521,681, incorporated herein by reference. For instance, the lactones are 3-(4-(2-acetoxyethoxy)phenyl)-5,7-di-tert-butyl-benzofuran-2- one, 5,7-di-tert-butyl-3-(4-(2-stearoyloxyethoxy)phenyl)benzofuran-2-one, 3,3'-bis(5,7-di-tert- butyl-3-(4-(2-hydroxyethoxy)phenyl)benzofuran-2-one), 5,7-di-tert-butyl-3-(4-ethoxyphenyl)-benzofuran-2-one, 3-(4-acetoxy-3,5-dimethylphenyl)-5,7-di-tert-butyl-benzofuran-2-one, 3-(3,5-dimethyl-4-pivaloyloxyphenyl)-5,7-di-tert-butyl-benzofuran-2-one, 3-(3,4-dimethylphenyl)-5,7-di-tert-butyl-benzofuran-2-one, 3-(2,3-dimethylphenyl)-5,7-di-tert-butyl-benzofuran-2-one, 5,7-di-tert-butyl-3-phenyl-3H-benzofuran-2-one, 5,7-di-tert-butyl-3-(5,6,7,8-tetra-hydro-2-naphthalenyl)-(3H)-benzofurn-2-one or 5,7-di-tert-butyl-3-(4-methoxyphenyi)-3H-benzofuran-2-one.

Suitable heat stabilizers are used to prevent the thermal degradation of resins during periods of exposure to elevated temperatures, in particular to stabilize chlorine comprising polymers, like for example polyvinylidene chloride (PVDC) and vinyl chloride copolymers (for example, vinyl chloride/vinyl acetate). Suitable types of primary heat stabilizers, include: mixed metal salt blends, organotin compounds and lead compounds. The primary heat stabilisers may be used in combination with secondary heat stabilizers. The secondary heat stabilizers are usually organophosphites and epoxy compounds, but polyols and beta diketones are also used.

Suitable Mixed metal stabilizers include barium/zinc (Ba/Zn) metal salts. Typical liquid barium, cadmium, and zinc stabilizer products consist of such salts as octoates, alkylphenolates, neodecanoates, naphthenates, and benzoates. Typical solid barium, cadmium, and zinc stabilizer products consist of the salts of such fatty acids as stearates or laurates. Generally, Ca/Zn and Ba/Zn are preferred for use in food-contact applications.

Suitable Organotin heat stabilizers include methyltin, butyltin and octyltin mercaptides, maleates, and carboxylates. Organotin stabilizers may be divided into sulfur-containing and sulfur-free products. Sulfur-containing products (mercaptides) provide excellent overall stabilization properties but suffer from odor and crossstaining problems. The nonsulfur organotins, such as the maleates, are less efficient heat stabilizers but do not suffer from odor problems and provide better light stability. Some octyltin mercaptoacetates and maleates, and to a lesser extent methyltin mercaptoacetates, have FDA approval for use in food-contact applications.

Suitable Lead heat stabilizers include organic- or inorganic-based products. Selected organic products consist of dibasic lead stearates and phthalates, while some inorganic lead products are tribasic lead sulfate, dibasic lead phosphite, and dibasic lead carbonate.

The primary stabalizers can be combined with secondary heat stabilizers, or the secondary heat stabilisers may be used by themselves.

Suitable secondary heat stabalizers include alkyl/aryl organophosphites, epoxy compounds, beta diketones and polyfunctional alcohols.

Suitable alkyl/aryl organophosphites include didecylphenyl, tridecyl, and triphenyl phosphites. A number organophosphite products have been given FDA approval for flexible vinyl applications. An example is tris (nonylphenyl) phosphite (TNPP).

Suitable epoxy compounds include those that are derived from unsaturated fatty oils and fatty acid esters, like for example epoxidized soybean and linseed oils and epoxy tallate. Epoxy tallate also increases light stability. Epoxy compounds can be formulated with metallic liquid stearates and, thus, can be sold to compounders as a one-package system if a constant ratio of stabilizer-to-epoxy is acceptable.

It is furthermore advantageous to use the oligomeric organic compound layer as dielectric coating.

The invention further relates to a laminate comprise a substrate layer provided with a metal or metal oxide layer, a vapour deposited oligomeric organic compound layer wherein the oligomeric compound has a molecular weight between 500 and 10000 Da, and a plastic film, the laminate having a lamination strength of about 1.0 N/25 mm (inch) or more as measured in a 90 degree tensile testing at 30 mm/min.

In a further embodiment of the invention, the laminate comprises a substrate, a metal or metaloxide layer, a vapour deposited oligomeric organic compound layer, and a further metal or metaloxide layer. The organic layer acts as a surface smoothening layer so that the defects on the first metal oxide layer is not transferred to the second metal oxide layer. In this way the organic layer decouples the defects in two sequential metal oxide layers. The alternating deposition of organic and metal oxide layer can be repeated in the vacuum (in one pumping) resulting in formation of a composite of organic and metal oxide layers with excellent barrier properties suitable for application in flexible electronics.

Suitable examples of metal layers include but are not limited to: alumina, chromium, silver, gold, or copper. Suitable examples of metaloxide layers include but are not limited to aluminium oxide, silicon oxide, zinc oxide, silicon nitride and the like.

In another embodiment, the composite layer of this invention comprises a substrate, a metal or metal oxide barrier layer with a protective layer consisting essentially of the oligomeric organic compound that has been vapour deposited in line.

In a further embodiment of the present invention, the laminate comprises an adhesive layer between the oligomeric organic compound layer and a plastic film.

In a further embodiment, the laminate comprises a pattern or figure on the oligomeric organic compound layer.

In a further embodiment, a film is directly extruded on the oligomeric organic compound layer, which may be printed.

In a further embodiment, the composite layer of this invention comprises a substrate, a metal or metal oxide barrier layer with a protective layer consisting essentially of the oligomeric organic compound that has been vapour deposited in line and then outside vacuum chamber has been printed and possibly over-lacquered. Such films are ideally suitable for label applications such as wrap around and pressure sensitive labels. Further applications include monowebs for confectionary using vertical form fill seal (VFFS) and horizontal form fill and seal (HFFS) packaging machines.

In a further embodiment, the composite layer of this invention comprises a substrate, a metal or metal oxide barrier layer with a protective layer consisting essentially of the oligomeric organic compound that has been vapour deposited in line and then outside vacuum chamber has been printed and then adhesive laminated with a sealant film. Alternatively the sealant film may be applied extrusion lamination or coating.

For printing all methods can be used such as Flexography, rotogravure, offset printing, digital printing, letterpress printing, inkjet printing and laser printing.

Inks generally comprise a binder, a pigment, additives and solvents. Following types of inks can be used:
1. UV inks
2. EB (electron beam) inks
3. PVB (Poly Vinyl Butyral) inks
4. PVC (Poly Vinyl Chloride) inks
5. Nitrocellulose (NC) inks
6. Polyamide inks
7. Polyurethane (PU) inks
8. PU/NC inks

UV inks are more preferred for Flexo than for Gravure, because of the viscosity. The ink may have too high viscosity for gravure and therefore the ink would not be able to reach all the holes in the gravure plate.

UV Curable screen printing ink is a 100% solid system: that is, it essentially does not contain solvent that must evaporate during the curing phase. The cure takes place through the interaction of the ink ingredients and a strong UV (ultra violet) light source in a dryer. Solvent inks may have better coverage, and they are relatively inexpensive, while having good durability. UV curable inks have the advantage of lack of VOC's, rapid curing and excellent color value. Some disadvantages can be: The ink is not applicable on all substrates, it cannot be printed on dark substrates; the outdoor durability may be limited, they may be less suitable for high levels of abrasion; they tend to be less flexible, and they are more sensitive to proper cure procedures.

EB inks are suitable as well. Both UV and EB systems typically use acrylate materials (although other special chemistries are available) that cure by free radical polymerization. In the case of UV curing, the UV light is absorbed by chemicals called photoinitiators. These materials convert the UV light into free radicals. The free radicals cause the acrylate materials to chemically react and form acrylic polymers. In EB curing, a photoinitiator is not needed. The energy of the electrons is enough to directly cause the acrylate materials to polymerize by opening the acrylate bonds to form free radicals. These radicals then attack the remaining acrylate bonds until the reaction reaches completion. UV curing and EB curing inks, coatings and adhesives, when properly formulated, applied and cured, can satisfy the needs of many applications. EB chemistry more easily meets the needs of low odor, low off-taste applications. For thick films, opaque colors and through-film curing, EB is more appropriate. UV/EB inks are quite common in food packaging. UV inks are mostly used for label applications. The potential for migration of hazardous photoinitiators in to the package limits the use of such types of inks.

PVB inks can be well used both in Flexo and in Gravure, as they are well soluble in alcohols, and partly soluble in esters. Polyvinylbutyral (PVB): Inks based on PVB resins are widely used for retort printing because of their effective adhesion and heat stability: The resins melt at about 110°C (230°F) but the molecules are stable up to about 250°C/482°F. PVB inks have some disadvantages: the most important is the incompatibility between the adhesion promoters used in PVB inks and nitrocellulose (NC). Printers using both NC and PVB inks must thoroughly clean presses and auxiliary equipment (hoses, ink pumps, ink containers, cylinders, etc) between runs to avoid poor print quality.

PVC inks are less suitable in Flexo, and more suitable in Gravure. PVC copolymers have long been used in inks for retort applications in Europe. These inks do not require adhesion promoters and they perform on plain and coated films, give excellent print results and can be laminated with most adhesives. There are, however, two disadvantages: PVC inks are only soluble in esters and ketones, making them unsuitable for flexo printing. The chlorine content also makes PVC inks difficult and expensive to dispose of - high temperature incineration is typically required.

Nitrocellulose inks (NC inks) are well suited for Flexo and for Gravure. Nitrocellulose -based inks are the modern global standard for most flexo and gravure printing; However, they are not suitable for retort applications because NC degrades at high temperatures. These inks also typically require PU and PA co-binders.

PA binders are used in both Flexo and Gravure. Polyamides (PA) are standard ink resins in North America, typically used with cellulose acetate butyrate (CAB) and PVB co-resins. PA inks provide good bond strength on many substrates and excellent printability; they are suitable for both flexo and gravure printing. They share the limitations of the PVB resins as they also require adhesion promoters, which make PA inks incompatible with NC.

Polyurethanes (PU) binders can be used both for Flexo and for Gravure. The PU resins in use today are employed mostly as co-binders in NC, PVB and PVC systems.

Binders for the inks may be the same as the binders for the primer as described above.

The colour of an ink system is created by using pigments or dyes. Typically, pigments are insoluble, whereas dyes are soluble, though sometimes these terms are used interchangeably in commercial literature. Ink pigments are both inorganic and organic. Most white inks contain titanium dioxide as the pigment; black color is created with carbon black. Metallic pigments like aluminium powder (aluminium bronze) and copper-zinc alloy powder (gold bronze) are used in novel silver and gold inks. Miscellaneous inorganic pigments provide luminescent and pearlescent effects.

Suitable pigments or dyes for printing inks are for example .Diarylide Yellow, Benzimidazolone (yellow or red), Disazopyrazolone (orange), Naphthol (red), Triarylcarbonium (red or blue), Cu Phthalocyanine (blue or green),

As an adhesive, solvent based, solventless and water based systems can be used. Solvent based and solventless systems are preferably based on 2-components polyurethane systems. Also 1-component adhesives can be used.

Very useful transparent laminates can be made with the oligomeric organic compounds which have been vapour deposited on an aluminium oxide or silicon oxide coated substrate. These laminates are excellent in retort processing, showing no de-lamination or loss of barrier after retort. The process is typically carried out at 121°C or more for period of 15 minutes or more. Such systems are also suitable for sterilization process with no de-lamination or loss of barrier after 60 minutes or more boiling at 95°C and ambient pressure. For retort & sterilization processes the metal oxide coated substrates top coated with organic compound are laminated against retort grade CPP and more preferably BOPA/CPP.

The oligomeric organic compound layer may be a top layer, it is however also possible that on the layer of organic compound further layers are present, for example further layers of metal or metal oxide, a layer of triazine, printing or a polymer layer (laminating film).

The oligomeric organic compound layer protects the metal (in particular alumina) layer against decrease in surface energy or surface tension. Unprotected alumina layers need corona treatment after some month of storage, in case a converter wants to make a laminate. It appears that the oligomeric organic layer overcomes the necessity to perform a corona treatment, thereby saving money, and speeding-up the lamination process.

In a preferred embodiment, the organic compound layer also improves the barrier properties because the oligomeric organic compound layer helps to protect the metal or metal-oxide layer against the impact of guiding rollers in the vacuum chamber and also by preventing direct contact with various rollers during downstream processing steps such as slitting, printing and lamination.

In a further preferred embodiment, the oligomeric organic layer further improvers the printability, not only by protecting the metal or metaloxide layer, but also because it is a compound with better intrinsic printability characteristics.

Preferably the composite layer, when laminated at the side of the organic compound layer with an adhesive and a plastic film is able to exhibit a lamination strength of about 1.5 N/inch or more, more preferably of about 2 N/inch or more, even more preferably of about 2.5 N/inch or more as measured with a tensile testing apparatus at 30 mm/min and at 90 degree. Generally, the upper limit of the lamination strength is not critical, but generally, this will be about 20 N/inch or less. The lamination of the composite layer for testing preferably is done with an appropriate urethane adhesive and laminated with a 50 µm thin polyethylene film. Thereafter, the lamination strength of the two films can be measured, and the failure mode can be observed. An appropriate adhesive is an adhesive that has such adhesion strength that the failure mode is not observed on the adhesion layer below 1.5 N/inch. The adhesion may be so high that the plastic film breaks. The value of the force necessary to break a film can in that case be taken as value for bond strength. It is also important that laminate show high seal strength with no delamination in the seal area.

Generally, packaging materials are divided in flexible packaging and rigid packaging. Flexible packaging materials generally are based on flexible webs based on plastic film, paper or sheet like materials, hereinafter named film. Rigid packaging generally has a certain shape (three dimensional form).

The composite layer according the invention, in particular the ones with a film as substrate may be used as such, but can also be applied on plastic, paper, cardboard, metal, in any shape or as an article, such as for example PET bottles.

In the case of rigid packaging, the substrate may be a plastic material, cardboard or paper material. Suitable examples of rigid packaging include bottles or pre-shaped packing boxes. Preferred examples of articles are articles made from PET or PP.

In one embodiment of the invention, the layer is part of a packing for food and drink products. Most preferred packaging products include a packing for coffee beans or milled coffee beans or a packing for beer.

In another embodiment of the invention, the laminate or composite layer is used in or on displays or other electronic products, preferably flexible electronics products. One example of an electronic flexible product is a flexible display. Other examples of useful electronic applications, which may be flexible or rigid, include solar, OLED protection and the like.

In another embodiment, composite layer as described here is used as a thin film encapsulation on top of rigid displays for protection of electronic components against action of gases such as oxygen and water vapour. Accordingly in the vacuum chamber and preferably in one pumping layers of organic compounds and metal oxides are deposited sequentially to produce a multi-layer composite with excellent barrier properties. Examples of rigid displays includes devices based on OLED and photovoltaic.

In another embodiment, oligomeric organic compound layers are unexpectedly suitable for use in solar systems, as either inorganic (crystalline and amorphous) or organic materials (dye-sensitized) must be protected against oxygen and water. Currently, often silicium or alumina oxides are used. However, these are too expensive because many layers are required to deliver the needed performance. Furthermore, the layers are brittle. It appeared that a combination of oligomeric organic compound, as a under- and/or toplayer on one metal oxide layer, or the combination thereof does provide a better solution. In a further embodiment, a number of oligomeric layers is used as protective and levelling layer between the metal or metal-oxide compound layers. Improved barrier performance is achieved by producing a multi-stack of organic/metal oxide layers.

In another embodiment, oligomeric organic compound layers are unexpectedly well suitable for use as pre-coating and/or top coating on metallized paper for packaging applications. Current papers for metallization are special types of paper with the structure: Paper/precoating(clay coating)/Alumina/topcoating. The paper is usually calendared to smooth the surface. Then a clay coating is applied by the paper manufacturer to smoothen the surface even more. This paper is then used for metallization. Both pre- and topcoat are applied off-line and very expensive. It appeared possible to apply special oligomeric organic compound coatings in-line both as pre-coat and topcoat eliminating the need to use clay coatings or other offline pre-coatings. For this, a webcoater with three evaporation sources can be used. First, from a oligomeric or polymeric organic compound evaporator (pre-coat), an oligomeric organic compound coating is applied, then Aluminum source, and then again an oligomeric organic compound layer as topcoat. The advantages are better barrier of Al and elimination of very tedious and expensive offline pre- and topcoat.

The oligomeric organic vapor deposited layer can be used as dielectric layer (insulating layer) between two metal (deposited) layers; the metal can be for example chromium, zirconium, copper, gold or silver. These can be used for examples in color-shifting pigments and layers for anti-counterfeiting applications.

The oligomeric organic vapor deposited layer can be deposited in a relatively simple way, because no chemical reactions are necessary, in contrast to for example acrylate polymerization, which generally requires electron beam or UV polymerisation.

Yet, in another embodiment the organic vapor deposited layer is produced by plasma polymerization, as plasma polymerization is a feasible method to be used in a vacuum chamber.

In particular it has now been found that plasma induced chemical vapor deposition (PECVD) of siloxane based materials such as hexamethyldisiloxane (HDMSO) produces soft organic layers which offer excellent protection of vacuum deposited inorganic barrier layer (e.g. Al, AlOx and SiOx) underneath.

A suitable example of a material used is plasma-polymerized includes hexamethyldisiloxane (pp- HMDSO). Deposition of the pp-HMDSO material layer is achieved by flowing an oxygen-containing gas and HMDSO gas in a PECVD chamber placed after the deposition chamber of the first inorganic barrier layer (e.g. Al, AlOx, SiOx). In this way, the first inorganic barrier layer is inline top coated with pp-HDMSO. During deposition of the pp-HMDSO layer, the ratio of the flow of oxygen-containing gas to the flow of HMDSO gas is controlled to control the organic/inorganic state and properties of the resulting pp-HMDSO layer.

In one embodiment, the oxygen-containing gas is oxygen gas (O₂). A high O₂/HMDSO flow ratio (e.g., greater than10) may be maintained during processing to deposit an inorganic pp-HMDSO layer having characteristics, such as the high density and low porosity barrier properties associated with inorganic films. A low O₂/HMDSO flow ratio (e.g, less than 2) may be maintained during processing to deposit an organic pp-HMDSO layer having properties, such as the low stress properties associated with organic films.

Control of the oxygen gas used during deposition of the pp-HMDSO layer can minimize potential reaction with residual silane if present in the gas line or inlet of the deposition chamber. The reaction between the oxygen gas and residual silane can result in undesirable particle formation in the pp-HMDSO layer, which has the potential for contaminating the vacuum coated multilayer film. One method of minimizing the potential for reaction with silane is to perform a gas-line purge between deposition processes. Alternatively, other gases such as nitrous oxide, which are less reactive with silane relative to oxygen gas, may be used. It has been found that the use of nitrous oxide gas (N₂O) as the oxygen-containing gas results in minimal reaction with residual silane, thereby reducing, if not eliminating, the need to thoroughly purge the gas lines and chamber after use of silane within the chamber. Thus, a high-quality pp-HMDSO layer can be deposited without any intervening purge process between the inorganic layer deposition process and the organic top coat deposition process.

Therefore, in one embodiment the oxygen-containing gas is nitrous oxide gas. A high N₂O/HMDSO flow ratio (e.g., greater than 10) may be maintained during processing to deposit a relatively inorganic pp-HMDSO layer having characteristics, such as the high density and low porosity barrier properties associated with inorganic films. A low N₂O/ HMDSO flow ratio (e.g, less than 2) may be maintained during processing to deposit an organic pp-HMDSO layer having properties, such as the low stress properties associated with organic films.

In an exemplary embodiment, the processing parameters of the pp-HMDSO layer may include an HMDSO flow rate (in standard cubic centimeters per minute, seem) between about 100 seem and about 800 seem, the power density may be between about 0.15 W/cm² and about 0.75 W/cm², the pressure may be between about 500 mTorr and about 2000 mTorr.

Plasma polymerized layer may be designed to have properties of a hybrid layer. A layer of material that is controlled through the deposition process, such as the flow ratio of gases, to be organic and have properties of organic materials, such as acrylate, methacrylate, acrylic acid, or the like, or inorganic and have properties of inorganic materials. An example of a material used in the hybrid layer is plasma-polymerized hexamethyldisiloxane (pp-HMDSO). During deposition of the pp-HMDSO film, the ratio of oxygen-containing gas (e.g., O₂ or N₂O) flow to HMDSO flow may be controlled to control the organic/inorganic properties of the resulting pp-HMDSO top coated layer.

Alternatively fluorinated derivatives of HDMSO may also be used. The top coated layer may be fluorinated plasma-polymerized hexamethyldisiloxane (pp-HMDSO:F) deposited in a PECVD chamber. Deposition of the pp-HMDSO:F layer is achieved by flowing one or more fluorine-containing gases and HMDSO gas along with either O₂ or N₂O gas. The fluorine-containing gas may be nitrogen fluoride (NF₃), silicon fluoride (SiF₄), fluorine gas (F₂), carbon tetrafluoride (CF₄), or any combination thereof. Fluorine doped plasma polymerized HMDSO layer has superior particle coverage performance and surface planarization effect. The resulting top coat layer has a fluorine content of less than 10 atomic percent.

During the deposition of the pp-HMDSO:F, the ratio of the flow rates of the fluorine-containing gas and the HMDSO gas may be between about 0.25 and about 1.5. If there is too much fluorine, the carbon in the HMDSO may be taken out. In one embodiment, the PECVD of the pp-HMDSO:F is performed under the following conditions. The SiF₄ has a flow rate of 125 standard cubic centimeters per minute (seem) and HMDSO has a flow rate of 300 seem. In other words, the ratio of SiF₄ to HMDSO is between about 0.40 to about 0.45. The plasma is generated at 700 W and the chamber pressure is about 1800 mtorr. The PECVD is deposited at about 80 °Celsius.

When depositing the top coat layer, the HMDSO is initially a liquid precursor that is vaporized before delivery to the chamber. To prevent formation of the undesired particles, spraying of the HMDSO needs to be reduced and/or eliminated. Thus, the precursor flow for the top coat layer is ramped up rather than simply turned on at the final-desired flow rate. The ramp up occurs in a two-step process whereby the first step includes introducing the silicon-carbon containing precursor, such as HMDSO at a flow rate per substrate surface area of between about 0.000375 sccm/mm² to about 0.000675 sccm/mm² while also introducing an inert gas, such as helium, at a flow rate per substrate surface area of between about 0.000375 sccm/mm² to about 0.000675 sccm/mm². An oxygen containing precursor, such as N₂O, is then introduced at a flow rate per substrate surface area of between about 0.003125 sccm/mm² and about 0.003375 sccm/mm² while the fluorine precursor is introduced at a flow rate per substrate surface area of between about 0.0003 sccm/mm² and about 0.0004 sccm/mm² . The second step lasts as long as the first step. During the second step, the precursors continue to flow, but the silicon-carbon containing precursor is increased to between about 0.000875 sccm/mm² to about 0.001125 sccm/mm², the inert gas is increased to between about 0.0007 sccm/mm² and about 0.0008 sccm/mm² and the fluorine precursor is increased to between about 0.000425 sccm/mm² and about 0.00055 sccm/mm². The oxygen containing precursor remains at the same flow rate.

In another embodiment the precursor for plasma polymerized layer may consist of allyl-based derivatives such as allyalcohols, acrylic acids or allyamines. For polymerization of such material other plasma polymerization methods can be used such as pulsed radio frequency plasma polymerization. An overview of all possible plasma polymerization methods is given in "A Review of Recent Advances in Plasma Polymerization" by MITCHEL SHEN and , ALEXIS T. BELL, Chapter 1, pp 1-33, ACS Symposium Series, Vol. 108, ISBN13: 9780841205109eISBN: 9780841206731, Publication Date (Print): July 23, 2009 and in "Plasma polymerization and plasma treatment of polymers. Review" by Yoshihito Osada, Polymer Science U.S.S.R., Volume 30, Issue 9, 1988, Pages 1922-1941.

In some cases it may be necessary to improve the adhesion of the first inorganic barrier layer with plasma polymerized top coat layer by inserting adhesion improvement layer between the first barrier layer and top coat layer. Preferably the adhesion improving layer is introduced inline (in one pumping) using the same PECVD process.

In another embodiment, a plasma polymerized layer is first applied before applying the inorganic layer (e.g. Al, AlOx or SiOx) followed by second plasma polymerized layer on top of the inorganic layer. In this way the first plasma polymerized layer acts an planarization layer improving barrier properties of inorganic layer and second plasma polymerized layer acts as an topcoat protecting the inorganic layer during downstream processing steps such as slitting, printing and lamination. The application of all these three layers is preferably carried out in one pumping.

The plasma polymerized top coat layer has a thickness of between about 2 nm to about 5000 nm. Preferably the top coat layer has a thickness of 5 nm to 100 nm, and even more preferably the top coat layer has a thickness of 10 nm to 50 nm. To achieve such thicknesses in a roll-to-roll set up at industrial speed (> 1 m/s) it may be necessary to place multiple PECVC units in series.

Surprisingly we have found that plasma polymerized layers as explained above offer excellent protection to inorganic barrier layer underneath during downstream packaging process used in the packaging industry such as slitting, printing and lamination.

Hence, the present invention also comprises an embodiment, wherein the process for preparing a composite layer, by applying an siloxane based material on a substrate with a metal or metal oxide layer by vapour deposition, comprises the steps of
a) providing a substrate layer,
b) applying a metal or metal oxide layer under reduced pressure on said substrate, and
c) vapour depositing the siloxane based material with plasma polymerisation to obtain a polymerised siloxane coating.

In yet another embodiment, the process for preparing a composite layer of the present invention comprises: applying an allyl or acrylate based material on a substrate with a metal or metal oxide layer by vapour deposition, further comprising the steps of
a) providing a substrate layer,
b) applying a metal or metal oxide layer under reduced pressure on said substrate, and
c) vapour depositing the allyl or acrylate based material while applying plasma polymerisation to obtain a polymerised coating.

The plasma polymerized layers can be used instead of the organic oligomer or polymer layer, and the preferences of the other constituents of the composite layers or the laminates described above, such as substrate, metal or metal oxide layer, inks, adhesives further films and the like equally apply to the embodiment with plasma polymerized layer.

The composite layer according the invention has favorable barrier properties, for example a low oxygen transmission rate (OTR) and a low water vapor transmission rate (WVTR), and is sufficient wear resistant. Therefore, the composite layer of the invention can be used as such in printing and laminating.

The OTR is generally measured in an atmosphere of 30 °C and 70% RH. The preferred values generally depend on the substrate, optical density of metal layer, and thickness of metal oxide. Barrier properties depend furthermore on thickness and type of organic layer either as a pre-coat and/or top coat on metal or metal oxide layer. In case the substrate is 20 µm biaxially oriented polypropylene (BOPP), the OTR generally will be about 40 cc/m²·24h or less, preferably about 30 cc/m²·24h or less and even more preferred about 20 cc/m²·24h or less. Generally, in case of BOPP, the OTR will be about 2 cc/m²·24h or higher, and for example may be about 5 cc/m²·24h or higher. The OTR can be measured with suitable apparatus, such as for example with an OXTRAN 2/20 manufactured by Modern Control Co. In case the substrate is a PET film, the OTR generally will be about 15 cc/m²·24h or less, preferably about 10 cc/m²·24h or less and even more preferred about 5 cc/m²·24h or less. Generally, in case of PET, the OTR will be about 0.5 cc/m²·24h or higher, and for example may be about 1 or 2 cc/m²·24h or higher

Water vapor permeability (WVTR) can measured with a PERMATRAN 3/31 manufactured by Modern Control Co, in an atmosphere of 40 °C and 90% RH. The preferred values will depend on the substrate. For example for 20 µm BOPP the WVTR is generally about 3 g/m²·24h or less, preferably about 2 g/m²·24h or less, and more preferably about 1 g/m²·24h or less. Generally, the vapor permeability will be about 0.1 g/m²·24h or more, for example about 0.2 g/m²·24h or more. For example for PET, the WVTR is generally about 8 g/m²·24h or less, preferably about 7 g/m²·24h or less, and more preferably about 4 g/m²·24h or less. Generally, the vapor permeability will be about 0.5 g/m²·24h or more, for example about 1 g/m²·24h or more.

Preferably, the laminate has an OTR and WVTR also for other substrates which conform to the values given in the former two paragraphs.

The composite layer, optionally further processed by for example printing and laminating, can be applied as or to all kind of packing materials, for example bottles, paper, sheet and films. The packing material protects very well its content from for example oxygen and moisture, in this way increasing shelf life of food and medical products or protecting electronic components from oxygen and moisture attack.

In one embodiment, the laminate comprises a PET or BOPP film as substrate, a metal or metal oxide layer on said substrate as barrier layer, an oligomeric organic compound layer as protective layer on the metal or metal-oxide layer, the laminate further comprising on the oligomeric organic compound layer a pattern or figure and an adhesive and thereon a further film, which may be a polyolefin film, such as preferably a PE film.

In-line coating of a substrate with a metal or metal oxide layer with an oligomeric organic compound preferably takes place in the same vacuum tool, but preferably a separate vacuum chamber. This yields a composite layer with a well activated alumina, so that sufficient adhesion is obtained if laminated, even after 3-6 month. In order to improve the adhesion of metal or metal-oxide, the film can be treated by an inline plasma unit prior deposition of metal or metal oxide (so-called pre-treatment plasma unit). Similarly in order to improve the adhesion of organic layer, the metal or meta-oxide can be treated by an inline plasma unit prior to deposition of organic layer (so-called post-treatment plasma unit). The process conditions for plasma (e.g. power, gases, etc) depend on type of film and organic layer.

The invention will be further elucidated by the following non-limiting examples.

### Examples 1-3 and comparative experiment 1

In a roll-to-roll coating apparatus equipped with a long heatable chamber coating experiments are performed. A biaxially oriented polypropylene film (BOPP) of 20 µm thickness with a length of 20,000 m is coated with aluminum (average optical density (OD) of 2.0), and subsequently with an oligomeric organic compound as shown in the table at a vacuum of 1x 10⁻³ mbar. The film speed is 10 m/sec.

The alumina coated roll is stored for 6 month, and thereafter further processed. The composite layers are laminated without plasma treatment with a further plastic film in order to measure the lamination strength.

The lamination strength is measured according to JIS Z0238 with a Tensilon instron tester, at a speed: of 30mm/min, the angle between the two films is 90 degree. As sealant (second film) LLDPE is used from Tohcello Co Ltd (TUX FCS), and as adhesive a 2 component polyurethane solvent based system from Mitsui Takeda Chemicals (Takelac A-515 and Takenate A50, which are mixed just before use).

The Oxygen transmission rate (OTR) is measured with OXTRAN 2/20 manufactured by Modern Control Cop, in an atmosphere of 30 °C and 70% RH.

| Example | Oligomeric organic compound | Stabiliser* | Thickness | Lamination strength N/cm (N/inch) | OTR** of composite layer |
|---|---|---|---|---|---|
| Comp Exp | None | | - | 0.39 (1.0) | Not determined |
| 1 | Poly-ethylene vinylalcohol (Mn 150000) | A+B | 200 nm | 1.18 (3.0) | 17 |
| 2 | Poly-ethylene vinylalcohol (Mn 100000) | B | 100 nm | 0.98 (2.5) | 13 |
| 3 | PET (Mn 40000) | C+D | 10 nm | 1.18 (3.0) | 20 |

| | | | | | |
|---|---|---|---|---|---|
| * Stabilizers used: A= Pentaerythritol tetrakis(3-(3,5-di-tert-butyl-4-hydroxyphenyl)propionate); B= Octadecyl-3-(3,5-di-tert.butyl-4-hydroxyphenyl)-propionate; C= Thiodiethylene bis[3-(3,5-di-tert.-butyl-4-hydroxy-phenyl)propionate]; D= Ethylenebis(oxyethylene)bis-(3-(5-tert-butyl-4-hydroxy-m-tolyl)-propionate): **OTR in cc/m²·24h | | | | | |

Part of the composite layer is dissolved in THF and the molecular weight of the oligomers in the solution is determined with gel chromatography. The molecular weights are on average (Mn) 3400, 7200 and 2800 respectively, and more than 90 wt% of the layer has a molecular weight below 20,000.

Thus, the polymers in the heating chamber are decomposed to a certain extent, to a form suitable for vapor deposition. The stabilizer in the polymer allows sufficiently long processing window that the full roll can be processed in a satisfactory manner.

## Claims

1. Process for preparing a composite layer, by applying an oligomeric organic compound layer on a substrate with a metal or metal oxide layer by vapour deposition, comprising the steps of
a) providing as substrate layer a plastic film,
b) applying a metal or metal oxide layer under reduced pressure on said substrate, and
c) vapour depositing the oligomeric organic compound on the metal or metal oxide layer while the film remains at reduced pressure, wherein the oligomeric compound is evaporated from an oligomeric or polymeric compound comprising a stabiliser.

2. Process according to claim 1, wherein after deposition on metal or metal oxide layer the oligomeric compound forms an amorphous phase, wherein amorphous is defined by X-ray diffraction (XRD), which should not show a diffraction pattern representing ordening of molecules or polymer chains below 5 nm.

3. The process according to any one of the preceding claims, wherein the process is performed in a roll-to-roll process at a speed of at least 1 m/s, preferably at least 6 m/s, and more preferably at least 8 m/s, and wherein the speed is less than 60 m/sec, wherein the process is performed with rolls of about 1 m wide or more, preferably, about 1.25 m wide or more, and preferably about 5 m wide or less, wherein the length of the roles used in the process of the invention is about 5000 m or more, preferably about 10000 m or more, and more preferably about 20000 m or more.

4. The process according to anyone of the preceding claims, wherein the process is performed in the production of composite layers and laminate films for food and medical packaging.

5. The process according to anyone of the preceding claims, wherein the process is performed with an oligomeric organic compound which is sufficient polar to adhere well to the substrate.

6. The process according to anyone of the preceding claims, wherein the molecular weight of the oligomeric organic compound as present on the metal or metal-oxide layer is higher than 500, preferably higher than 1000, wherein the oligomeric organic compound is not polymerized on the surface, and
wherein about 50 wt% of the oligomeric organic compound layer will have a molecular weight lower than about 30,000.

7. The process according to anyone of the preceding claims, wherein the oligomers or polymers evaporated in the heating chamber is chosen from the group consisting of polyvinylacetate, polyvinylalcohol (PVOH), thermoplastic polyester (like PET or PBT), polylactides, polyglycolides, polylactones, polyhydroxybutyrate-valerate polymers, polyamides (nylons), polycarbonates, ethylene-acrylic polymers, ethylene vinyl alcohol, chlorinated polyethylenes, polyurethanes, styrene-maleic acid anhydride copolymers, vinylidene chloride polymers.

8. The process according to anyone of claims 1-6, wherein the oligomers or polymers evaporated in the heating chamber is chosen from the group consisting of polyolefins like polyethylene or polypropylene, and polystyrene, and wherein polar groups are introduced during the evaporation step with a plasma treatment using oxygen as plasma gas, in the space between the evaporator and the deposition surface.

9. The process according to anyone of the preceding claims, wherein the oligomeric organic compound layer is made from oligomers or polymers, wherein the oligomer or polymers used as material in the evaporator comprises an antioxidant, such as phenolic anti-oxidants, organic phosphorus compounds and lactone (benzofuranone) stabilizers.

10. Process according to claim 1, wherein the oligomeric organic compound is a siloxane based material, vapour deposited with plasma polymerisation to obtain a polymerised siloxane coating.

11. Process according to claim 1, wherein the oligomeric organic compound is an allyl or acrylate based material, vapour deposited while applying plasma polymerisation to obtain a polymerised coating.

12. Process according to any one of claims 10 or 11, in combination with claims 3 and 4.

13. Composite layer obtained with a process according to any one of the preceding claims.

14. Laminate comprising a composite layer according to claim 13, and a further film, provided on the oligomeric organic compound layer, wherein preferably the laminate comprises an adhesive layer between the oligomeric organic compound layer and the further plastic film, or wherein the laminate is prepared by extrusion lamination or coating.

15. Laminate according to claim 14 or composite layer according to claim 13, wherein the laminate or composite layer comprises a printed pattern, wherein the metal or metal oxide layer is a layer from aluminium, aluminium oxide, magnesium oxide, silicium oxide or silicium nitride.

## Patentansprüche

1. Verfahren zur Herstellung einer Verbundschicht durch Aufbringen einer oligomeren organischen Verbindungsschicht auf ein Substrat mit einer Metall- oder Metalloxidschicht durch Gasphasenabscheidung, umfassend die Schritte:
a) Bereitstellen einer Kunststofffolie als Substratschicht,
b) Aufbringen einer Metall- oder Metalloxidschicht unter vermindertem Druck auf das Substrat und
c) Gasphasenabscheiden der oligomeren organischen Verbindung auf der Metall- oder Metalloxidschicht, während die Folie bei reduziertem Druck verbleibt, wobei die oligomere Verbindung aus einer oligomeren oder polymeren Verbindung verdampft wird, die einen Stabilisator umfasst.

2. Verfahren nach Anspruch 1, wobei die oligomere Verbindung nach dem Abscheiden auf einer Metall- oder Metalloxidschicht eine amorphe Phase bildet, wobei amorph durch Röntgenbeugung (XRD) definiert wird, die kein Beugungsmuster aufweisen sollte, das die Anordnung von Molekülen oder Polymerketten unter 5 nm darstellt.

3. Verfahren nach einem der vorhergehenden Ansprüche, wobei das Verfahren in einem Rolle-zu-Rolle-Verfahren mit einer Geschwindigkeit von mindestens 1 m/s, bevorzugt mindestens 6 m/s und weiter bevorzugt mindestens 8 m/s durchgeführt wird, und wobei die Geschwindigkeit weniger als 60 m/sec beträgt, wobei das Verfahren mit Rollen von etwa 1 m Breite oder mehr, bevorzugt etwa 1,25 m breit oder mehr, und bevorzugt etwa 5 m breit oder weniger durchgeführt wird, wobei die Länge der in dem Verfahren der Erfindung verwendeten Rollen etwa 5000 m oder mehr, bevorzugt etwa 10000 m oder mehr, und insbesondere etwa 20000 m oder mehr beträgt.

4. Verfahren nach einem der vorhergehenden Ansprüche, wobei das Verfahren bei der Herstellung von Verbundschichten und Laminatfolien für Lebensmittelverpackungen und medizinische Verpackungen durchgeführt wird.

5. Verfahren nach einem der vorhergehenden Ansprüche, wobei das Verfahren mit einer oligomeren organischen Verbindung durchgeführt wird, die ausreichend polar ist, um gut an dem Substrat zu haften.

6. Verfahren nach einem der vorhergehenden Ansprüche, wobei das Molekulargewicht der oligomeren organischen Verbindung, wie sie auf der Metall- oder Metalloxidschicht vorhanden ist, höher als 500, bevorzugt höher als 1000 beträgt, wobei die oligomere organische Verbindung nicht auf der Oberfläche polymerisiert ist, und
wobei etwa 50 Gew.-% der Schicht der oligomeren organischen Verbindung ein Molekulargewicht von weniger als etwa 30000 aufweisen wird.

7. Verfahren nach einem der vorhergehenden Ansprüche, wobei die in der Heizkammer verdampften Oligomere oder Polymere ausgewählt sind aus der Gruppe bestehend aus Polyvinylacetat, Polyvinylalkohol (PVOH), thermoplastischem Polyester (wie PET oder PBT), Polylactiden, Polyglykoliden, Polylactonen, Polyhydroxybutyrat-Valerat-Polymeren, Polyamiden (Nylons), Polycarbonaten, Ethylen-Acryl-Polymeren, EthylenVinylalkohol, chlorierte Polyethylenen, Polyurethanen, Styrol-Maleinsäureanhydrid-Copolymeren, Vinylidenchlorid-Polymeren.

8. Verfahren nach einem der Ansprüche 1-6, wobei die in der Heizkammer verdampften Oligomere oder Polymere ausgewählt sind aus der Gruppe bestehend aus Polyolefinen, wie Polyethylen oder Polypropylen und Polystyrol, und wobei polare Gruppen während des Verdampfungsschrittes mit einer Plasmabehandlung unter Verwendung von Sauerstoff als Plasmagas in den Raum zwischen dem Verdampfer und der Abscheidungsoberfläche eingebracht werden.

9. Verfahren nach einem der vorhergehenden Ansprüche, wobei die Schicht der oligomeren organischen Verbindung aus Oligomeren oder Polymeren hergestellt wird, wobei das Oligomer oder die Polymere, die als Material in dem Verdampfer verwendet werden, ein Antioxidationsmittel, wie phenolische Antioxidationsmittel, organische Phosphorverbindungen und Lakton (Benzofuranon)-Stabilisatoren, umfassen.

10. Verfahren nach Anspruch 1, wobei die oligomere organische Verbindung ein Material auf Siloxanbasis ist, das mit Plasmapolymerisation gasphasenabgeschieden wird, um eine polymerisierte Siloxanbeschichtung zu erhalten.

11. Verfahren nach Anspruch 1, wobei die oligomere organische Verbindung ein Material auf Allyl- oder Acrylatbasis ist, das während der Anwendung von Plasmapolymerisation gasphasenabgeschieden wird, um eine polymerisierte Beschichtung zu erhalten.

12. Verfahren nach einem der Ansprüche 10 oder 11 in Kombination mit den Ansprüchen 3 und 4.

13. Verbundschicht, die mit einem Verfahren nach einem der vorhergehenden Ansprüche erhalten wird.

14. Laminat, umfassend eine Verbundschicht nach Anspruch 13 und eine weitere Folie, der auf der Schicht der oligomeren organischen Verbindung vorgesehen ist, wobei bevorzugt das Laminat eine Klebeschicht zwischen der Schicht der oligomeren organischen Verbindung und der weiteren Kunststofffolie umfasst, oder wobei das Laminat durch Extrusionslaminieren oder Beschichten hergestellt wird.

15. Laminat nach Anspruch 14 oder Verbundschicht nach Anspruch 13, wobei das Laminat oder die Verbundschicht ein gedrucktes Muster umfasst, wobei die Metall- oder Metalloxidschicht eine Schicht aus Aluminium, Aluminiumoxid, Magnesiumoxid, Siliziumoxid oder Siliziumnitrid ist.

## Revendications

1. Procédé de préparation d'une couche composite, par application d'une couche de composé organique oligomère sur un substrat avec une couche de métal ou d'oxyde métallique par dépôt en phase vapeur, comprenant les étapes consistant à :
a) se procurer comme couche de substrat un film plastique ;
b) appliquer sur ledit substrat une couche de métal ou d'oxyde métallique sous pression réduite ; et
c) déposer en phase vapeur le composé organique oligomère sur la couche de métal ou d'oxyde métallique alors que le film reste à pression réduite, le composé oligomère s'évaporant à partir d'un composé oligomère ou polymère comprenant un stabilisant.

2. Procédé selon la revendication 1, dans lequel, après dépôt sur la couche de métal ou d'oxyde métallique, le composé oligomère forme une phase amorphe, amorphe étant défini par diffraction des rayons X (XRD), qui ne devrait pas présenter un diagramme de diffraction représentant une organisation de molécules ou de chaînes polymères au-dessous de 5 nm.

3. Procédé selon l'une quelconque des revendications précédentes, dans lequel le procédé est effectué dans un procédé rouleau à rouleau à une vitesse d'au moins 1 m/s, de préférence d'au moins 6 m/s, et, de façon davantage préférée, d'au moins 8 m/s, et dans lequel la vitesse est inférieure à 60 m/s, dans lequel le procédé est effectué avec des rouleaux d'une largeur d'environ 1 m ou plus, de préférence d'environ 1,25 m ou plus, et, de préférence, d'environ 5 m ou moins, dans lequel la longueur des rouleaux utilisés dans le procédé de l'invention étant d'environ 5000 m ou plus, de préférence d'environ 10000 m ou plus, et, de façon davantage préférée, d'environ 20000 m ou plus.

4. Procédé selon l'une quelconque des revendications précédentes, dans lequel le procédé est effectué dans la production de couches composites et de films stratifiés pour l'emballage d'aliments et de médicaments.

5. Procédé selon l'une quelconque des revendications précédentes, dans lequel le procédé est effectué avec un composé organique oligomère qui est suffisamment polaire pour bien adhérer au substrat.

6. Procédé selon l'une quelconque des revendications précédentes, dans lequel la masse moléculaire du composé organique oligomère tel que présent sur la couche de métal ou d'oxyde métallique est supérieure à 500, de préférence supérieure à 1000, le composé organique oligomère n'étant pas polymérisé sur la surface, et dans lequel environ 50 % en poids de la couche de composé organique oligomère aura une masse moléculaire inférieure à environ 30000.

7. Procédé selon l'une quelconque des revendications précédentes, dans lequel les oligomères ou polymères s'évaporant dans la chambre chauffante sont choisis dans le groupe consistant en acétate de polyvinyle, alcool polyvinylique (PVOH), polyester thermoplastique (comme le PET ou le PBT), polylactides, polyglycolides, polylactones, polymères polyhydroxybutyrate-valérate, polyamides (Nylons), polycarbonates, polymères éthylène acrylique, éthylène-alcool vinylique, polyéthylènes chlorés, polyuréthanes, copolymères styrène-anhydride d'acide maléique, polymères de chlorure de vinylidène.

8. Procédé selon l'une quelconque des revendications 1 à 6, dans lequel les oligomères ou polymères s'évaporant dans la chambre chauffante sont choisis dans le groupe consistant en polyoléfines comme le polyéthylène ou le polypropylène, et polystyrène, et dans lequel des groupes polaires sont introduits pendant l'étape d'évaporation avec un traitement par plasma à l'aide d'oxygène comme gaz de plasma, dans l'espace entre l'évaporateur et la surface de dépôt.

9. Procédé selon l'une quelconque des revendications précédentes, dans lequel la couche de composé organique oligomère est faite d'oligomères ou de polymères, l'oligomère ou les polymères utilisés comme matière dans l'évaporateur comprenant un anti-oxydant, tels que les anti-oxydants phénoliques, les composés organiques du phosphore et les stabilisateurs lactones (benzofuranone).

10. Procédé selon la revendication 1, dans lequel le composé organique oligomère est une matière à base de siloxane, déposée en phase vapeur avec une polymérisation par plasma pour obtenir un revêtement de siloxane polymérisé.

11. Procédé selon la revendication 1, dans lequel le composé organique oligomère est une matière à base d'allyle ou d'acrylate, déposée en phase vapeur tout en appliquant une polymérisation par plasma pour obtenir un revêtement polymérisé.

12. Procédé selon l'une quelconque des revendications 10 ou 11, en combinaison avec les revendications 3 et 4.

13. Couche composite obtenue par un procédé selon l'une quelconque des revendications précédentes.

14. Stratifié comprenant une couche composite selon la revendication 13, et un autre film, disposé sur la couche de composé organique oligomère, dans lequel, de préférence, le stratifié comprend une couche adhésive entre la couche de composé organique oligomère et l'autre film plastique, ou dans lequel le stratifié est préparé par extrusion-laminage ou revêtement.

15. Stratifié selon la revendication 14 ou couche composite selon la revendication 13, dans lequel(laquelle) le stratifié ou la couche composite comprend un motif imprimé, la couche de métal ou d'oxyde métallique étant une couche d'aluminium, d'oxyde d'aluminium, d'oxyde de magnésium, d'oxyde de silicium ou de nitrure de silicium.
